# FASCICULE DE BREVET EUROPEEN

(11) **EP 2 765 577 B1**
(45) Date de publication et mention de la délivrance du brevet: **22.01.2020**
(21) Numéro de dépôt: 14154349.6
(22) Date de dépôt: 07.02.2014
(51) Int. Cl.: G11C 13/00

(54) **Méthode de programmation d'une mémoire résistive non volatile**
Programmierungsverfahren eines nicht flüchtigen, resistiven Speichers
Method for programming a non-volatile resistive memory

(30) Priorité: 08.02.2013 FR 1351095
(43) Date de publication de la demande: 13.08.2014
(73) Titulaire: COMMISSARIAT À L'ÉNERGIE ATOMIQUE ET AUX ÉNERGIES ALTERNATIVES, 75015 Paris (FR)
(72) Inventeur: Perniola, Luca, 38360 Noyarey (FR)
(74) Mandataire: Hautier, Nicolas

(56) Documents cités:
- EP-A1- 2 402 953
- WO-A1-2007/141865
- US-A1- 2012 081 946
- P. Candelier ET AL: "One time programmable drift antifuse cell reliability", 2000 IEEE International Reliability Physics Symposium Proceedings. 38th Annual (Cat. No.00CH37059), 1 January 2000 (2000-01-01), pages 169-173, XP055304291, DOI: 10.1109/RELPHY.2000.843909 ISBN: 978-0-7803-5860-7

## Description

### DOMAINE TECHNIQUE DE L'INVENTION

La présente invention concerne, en général, les mémoires résistives non volatiles, et plus particulièrement, les mémoires résistives pouvant être utilisée dans le cadre d'un processus industriel de fabrication de systèmes embarqués où il est très avantageux de pouvoir les préprogrammer dans leur environnement de fabrication sans que les informations stockées puissent être ensuite perdues en raison des contraintes thermiques subies, notamment celles d'assemblage comprenant des étapes de soudage ou de brasage par refusion des composants. L'invention porte notamment sur un procédé de programmation de cellules mémoire résistives et un dispositif microélectronique intégrant comprenant une matrice de cellules mémoire préprogrammées selon le procédé.

### ÉTAT DE LA TECHNIQUE

Les systèmes embarqués informatisés font toujours très largement appel, en plus des éléments électroniques, optiques ou mécaniques propres à chaque système, à l'utilisation de microprocesseurs ou de microcontrôleurs et aux mémoires électroniques nécessaires pour assurer leur fonctionnement. Typiquement, tous les composants constituant un système embarqué sont assemblés sur un ou plusieurs circuits imprimés ou cartes électroniques souvent aussi désignés par leur vocable anglais de PCB, c'est-à-dire « printed circuit board ». L'assemblage est généralement automatisé dans une chaîne de fabrication. Les composants électroniques se présentent le plus souvent sous la forme de composants destinés à être montés en surface (sans broches traversantes). Ils sont alors simplement posés sur le circuit imprimé par une machine de placement. Préalablement, un dépôt d'une pâte de soudage ou de brasage sur les terminaisons des composants et/ou celles du circuit imprimés aura été effectué. On fait ensuite passer le circuit imprimé sur lequel les composants ont été placés dans un four de chauffage, typiquement un four dit tunnel où le gradient de température est réglé pour faire fondre la pâte déposée qui assure, après refroidissement, une fixation mécanique des composants et un excellent contact électrique. Cette opération standard de fabrication d'un circuit imprimé est qualifiée de soudage ou brasage par refusion ou encore, dans la littérature technique en anglais, de « solder reflow ».

Presque toujours, une partie au moins des mémoires constituant un système embarqué est de type non volatile. Par exemple, pour pouvoir y stocker de façon permanente le code opérationnel, généralement appelé microcode, du ou des microprocesseurs ou microcontrôleurs qui servent à réaliser la fonction pour laquelle le système embarqué a été conçu. Il est alors de pratique courante que le processus de fabrication demande que la partie non volatile des mémoires puisse être programmée avant leur montage sur le circuit imprimé. Un avantage très important de cette façon de faire est qu'on peut alors, par exemple, préprogrammer dans la partie non volatile un code spécifique destiné à tester le circuit imprimé dès après assemblage de façon à vérifier son intégrité. Un autre exemple d'avantage lié à la possibilité de pouvoir préprogrammer les mémoires non volatiles concerne les cartes à puce sécurisées souvent désignées par leur vocable anglais de « secure smart cards ». Les émetteurs de telles cartes, par exemple les banques, préfèrent de beaucoup que les données confidentielles qu'elles contiennent puissent y être introduites avant assemblage afin de ne pas avoir à contrôler la distribution de ces informations sensibles au-delà de la chaîne de fabrication.

Si le code opérationnel ou les données fonctionnelles que doivent contenir une mémoire non volatile n'ont pas été préprogrammés ils devront alors pouvoir être chargés in situ, c'est-à-dire dans la mémoire non volatile après qu'elle a été assemblée et interconnectée avec les autres composants sur le circuit imprimé. Des moyens ont été développés depuis longtemps par l'industrie de la microélectronique pour assurer cette fonction après assemblage. Une pratique courante est d'utiliser les circuits de tests qui sont contenus dans la quasi-totalité des circuits développés par cette industrie notamment les circuits dits JTAG, acronyme de l'anglais « Joint Test Action Group » qui désigne un groupe de travail qui a permis de définir une stratégie et des moyens de test des circuits imprimés dès le milieu des années 80 afin de pouvoir s'assurer, après fabrication, du bon fonctionnement de circuits de plus en plus complexes. Devenu un standard, les circuits JTAG permettent d'accéder individuellement aux composants assemblés sur un circuit imprimé à travers une interface série spécialisée qui peut aussi permettre une programmation in situ de la partie mémoire non volatile. La vitesse d'accès intrinsèquement faible et la bande passante disponible limitée de cette méthode font que le chargement du code est une opération qui peut prendre beaucoup de temps et ralentir la chaîne de fabrication.

D'autres moyens ont été conçus pour la programmation in situ de la partie non volatile des mémoires qui ont leurs propres inconvénients comme de nécessiter des points de connexion spécialisés qui n'auront aucune utilité fonctionnelle et/où une interface dédiée à cette fonction pour permettre d'une part, l'écriture du code dans la partie mémoire non volatile, et d'autre part, le contrôle des autres composants afin qu'ils puissent être inhibés pour ne pas interférer avec le chargement du code. Ceci ne manque pas de compliquer grandement la conception du système embarqué et nécessite aussi généralement le développement d'un outil de programmation spécialisé pour le chargement du code après assemblage dans la ligne de fabrication.

Chaque fois que c'est possible on préfère donc charger tout le code nécessaire, c'est-à-dire non seulement le code de test mais aussi le code fonctionnel, avant assemblage. Ceci évite d'avoir recours à une programmation in situ avec tous les inconvénients brièvement mentionnés ci-dessus.

Les mémoires non volatiles utilisées actuellement sont essentiellement des mémoires dites Flash dans lesquelles chaque point mémoire est un transistor métal-oxyde-semiconducteur (MOS) possédant une grille flottante dans lequel on piège des porteurs. La programmation de ces mémoires se fait en appliquant sur les électrodes des tensions plus élevées que celles utilisées pour leur lecture. Ces tensions permettent d'amener dans la grille flottante des charges, ou à les évacuer, afin de modifier de façon permanente, en lecture, le seuil de conduction du transistor pour pouvoir y stocker au moins deux niveaux électriques différents c'est-à-dire un bit d'information. Le piégeage et l'évacuation des porteurs se fait à travers la couche d'oxyde très mince formant la grille du transistor MOS en mettant en oeuvre des effets quantiques du type effet tunnel ou électron chaud. Ce type de stockage non volatile n'est pas particulièrement affecté par la température. Les mémoires Flash supportent très bien la programmation avant assemblage. Leur contenu n'est pas altéré par l'opération de soudage par refusion décrite précédemment dans laquelle, typiquement, la température maximum atteinte est de l'ordre de 245°C pour les pâtes de soudage contenant du plomb. L'emploi de pâtes sans plomb, maintenant requis pour leur caractère non polluant, augmente la température jusqu'à 260° C voire plus, ce qui reste sans effet négatif sur la rétention des données préprogrammées dans ce type de mémoire. L'inconvénient principal des mémoires Flash est que leur programmation nécessite, comme on l'a vu ci-dessus, de devoir appliquer des tensions et courants importants pour transférer des charges dans ou depuis la grille flottante. Leur écriture est une opération relativement lente et compliquée qui peut avoir à se faire, en fonction de leur structure interne de type dit ET ou OU, sur des blocks de cellules qui doivent être effacés avant d'être réécrits avec les nouvelles données.

Il existe par ailleurs d'autres types de mémoires désignées cellules mémoire à changement de phase. Les documents WO-2007-141865 et EP-2-402-953 concernent notamment l'insertion, entre les électrodes formant la cellule mémoire, d'une couche formée en un matériau à changement de phase de type chalcogénure. Dans ces dispositifs, pour faire passer le chalcogénure d'un état cristallin à un état amorphe, il est nécessaire d'apporter au chalcogénure de la chaleur, dans une plage de température restreinte, afin d'engendrer une commutation de la cellule mémoire d'un état (par exemple, SET) à un autre état (par exemple, RESET).

C'est pourquoi les concepteurs de systèmes embarqués se tournent maintenant vers l'emploi d'autres types de mémoires non volatiles qui ne présentent pas ces inconvénients. Il s'agit notamment des mémoires dites « résistives » globalement désignées par le terme RRAM, acronyme de l'anglais « resistive random accès memory » c'est-à-dire « mémoire résistive à accès aléatoire » où la mémorisation se fait en modifiant électriquement, de façon réversible, le matériau qui compose chaque cellule de façon à ce qu'il puisse prendre au moins deux valeurs distinctes de résistance pour y stocker un bit d'information. Parmi les différents types de mémoires résistives existantes celles dont le matériau de base est un diélectrique, normalement isolant, sont plus particulièrement considérées. Ces mémoires désignées par le terme OxRAM, qui fait référence à leur emploi d'un oxyde (Ox) comme matériau diélectrique, mettent en oeuvre un mode de fonctionnement dans lequel au moins un filament conducteur ou chemin conducteur, quelle que forme qu'il prenne, peut toutefois être formé entre deux électrodes séparées par l'oxyde après application d'une tension suffisamment importante entre celles-ci. Une fois que le filament a été formé, un état à faible résistance, généralement qualifié de LRS, de l'anglais « low resistance state », est obtenu. Cet état peut être inversé par une opération dite de « RESET », afin de remettre la mémoire dans un second état à forte résistance ou HRS de l'anglais « high resistance state », opération au cours de laquelle le ou les filaments sont rompus. Une fois que le filament a été formé une première fois une opération dite de « SET » peut remettre à nouveau la mémoire dans un état à faible résistance ou LRS en reformant au moins un filament. Cette opération nécessite l'application de tensions moins élevées.

Cependant, contrairement à l'état à haute résistance, c'est généralement l'état à faible résistance où l'on forme au moins un filament conducteur qui est thermiquement instable. La durée de vie des filaments conducteurs, et donc le temps de rétention des informations stockées sous cette forme, diminue très rapidement avec l'augmentation de la température à laquelle ils sont soumis. Pour la température maximale de 260°C mentionnée précédemment, qui est atteinte durablement pendant une opération de soudage par refusion, le temps de rétention peut alors s'avérer être insuffisant pour garantir d'une façon fiable la rétention des informations qui y auraient été programmées préalablement. Les mémoires résistives de type RRAM ne peuvent donc être utilement préprogrammées avant assemblage puisque les informations stockées seront alors perdues lors de la phase de soudage par refusion.

Le document US2012081946 décrit une solution dans laquelle un état hautement résistif obtenu par programmation de la cellule est utilisé.

Le document "One time programmable drift antifuse cell reliability" de P. CANDELIER ET AL publié en 2000 dans IEEE INTERNATIONAL RELIABILITY PHYSICS SYMPOSIUM PROCEEDINGS aux pages 169-173 décrit un procédé comme défini dans le préambule de la revendication 1.

Il serait donc particulièrement avantageux de disposer de cellules mémoires permettant une grande densité d'intégration, au moins identique sinon meilleure que les mémoires Flash mentionnées ci-dessus, tout en autorisant une écriture plus rapide que ces dernières et qui seraient aussi capables de retenir leur information à des températures relativement élevées. La présente invention vise à répondre à cet objectif.

Un autre objectif de l'invention est de proposer une solution pour permettre à une cellule mémoire de ne pas perdre, lors d'une opération d'assemblage, une programmation effectuée au préalable.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Selon un mode de réalisation, l'invention porte sur un procédé de préprogrammation d'une matrice de cellules mémoire résistives non volatiles, conforme à la revendication 1.

Il s'avère que l'état résistif originel (HRS originel) reste stable même lorsque la cellule reçoit une quantité de chaleur importante du fait de l'étape d'assemblage qui comprend par exemple une étape de soudage ou de brasage. Après assemblage, les cellules laissées après programmation dans l'état résistif originel demeurent dans cet état. Les cellules amenées électriquement depuis l'état résistif originel (HRS originel) jusqu'à l'autre état résistif (LRS, HRS programmé) peuvent en revanche être altérées par l'apport de chaleur de l'étape d'assemblage et voir leur état résistif être modifié. Néanmoins, ces cellules, mêmes fortement altérées, ne retrouvent en aucun cas leur état résistif originel. Par ailleurs, il s'avère que dans tous les cas, l'application d'une tension de lecture permet d'identifier, après assemblage, si une cellule se trouve ou non dans l'état résistif originel (HRS originel).

L'invention permet ainsi de différencier, après assemblage :
- les cellules qui n'ont pas été programmées avant assemblage. Ces cellules demeurent dans l'état résistif originel après assemblage.
par rapport :
- aux cellules qui ont été programmées avant assemblage. Ces cellules ont peu être été altérées par l'assemblage, mais quoiqu'il en soit, elles ne sont pas dans l'état résistif originel. Ces cellules sont donc toutes les cellules qui ne sont pas dans l'état résistif originel.

Cette différenciation est par exemple effectuée en appliquant une tension comprise dans l'intervalle de lecture. Cette application d'une tension de lecture n'altère pas la cellule mémoire.

Si une cellule n'est pas dans l'état résistif originel on pourra donc en conclure qu'elle avait été programmée avant assemblage.

L'invention offre ainsi une solution simple et robuste pour retrouver la programmation d'une matrice de cellules mémoire résistives non volatiles après une étape de montage au cours duquel un stress thermique important est appliqué à la matrice.

Cette invention présente un outre un avantage en terme de dissipation de puissance. En effet, la lecture des cellules mémoire peut être effectuée en appliquant une faible tension.

De manière facultative, le procédé selon l'invention comprend au moins l'une quelconque des étapes et caractéristiques suivantes.

Selon un mode de réalisation, le courant passant entre les deux électrodes conductrices traverse le matériau diélectrique. De préférence, tout le courant passant d'une électrode conductrice à l'autre traverse nécessairement le matériau diélectrique.

Selon un mode de réalisation, le matériau diélectrique est au contact de chacune des deux électrodes conductrices. De préférence, seul le matériau diélectrique est au contact de chacune des deux électrodes conductrices. Ainsi, il n'y a pas un autre matériau entre les deux électrodes conductrices sur le passage du courant. De préférence, il n'y a pas un autre matériau entre les deux électrodes conductrices. En particulier, il n'y a pas de matériau à changement de phase entre les deux électrodes conductrices. De manière plus générale, la cellule résistive ne comprend pas de matériau à changement de phase.

Selon un mode de réalisation de l'invention, ledit autre état résistif est un deuxième état résistif (LRS) directement obtenu par application d'une tension depuis l'état résistif originel (HRS originel).

Avantageusement, selon un mode de réalisation, le procédé comprend les étapes suivantes, effectuées après assemblage du composant contenant ladite matrice sur le support:
- identifier si la cellule mémoire est dans l'état résistif originel (HRS originel);
- si la cellule mémoire n'est pas dans l'état résistif originel (HRS originel), appliquer à la cellule mémoire une tension dont l'amplitude est supérieure audit intervalle de lecture de manière à ramener ou à maintenir la cellule mémoire dans ledit deuxième état résistif (LRS).

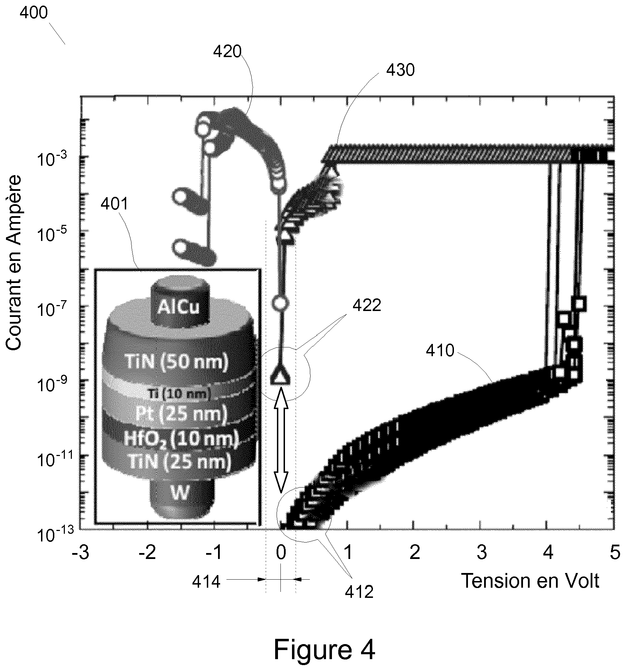

Cette tension est supérieure audit intervalle de lecture en valeur absolue pour un fonctionnement bipolaire et unipolaire. En fonctionnement bipolaire, pour faire un RESET électrique, il faut appliquer une tension négative (ou opposée par rapport à la tension de forming), comme cela sera détaillé par la suite en référence à la figure 4.

En fonctionnement unipolaire, pour faire un RESET électrique il suffit de rester dans la même polarisation et d'augmenter de tension par rapport aux tensions utilisées en lecture.

Alternativement, selon un autre mode de réalisation, le procédé comprend les étapes suivantes, effectuées après assemblage du composant contenant ladite matrice sur le support:
- identifier si la cellule mémoire est dans l'état résistif originel (HRS originel);
- si la cellule mémoire n'est pas dans l'état résistif originel (HRS originel), appliquer à la cellule mémoire une tension supérieure audit intervalle de lecture de manière à amener la cellule mémoire dans un troisième état résistif (HRS programmé) dans lequel la résistance la cellule mémoire présente une résistance que l'on peut différencier de la résistance de la cellule mémoire dans l'état résistif originel (HRS originel) par application d'une tension prise dans l'intervalle de lecture.

L'invention offre ainsi une solution simple et robuste pour conserver la programmation d'une matrice de cellules mémoire résistives non volatiles après une étape de montage au cours duquel un stress thermique important est appliqué à la matrice.

Cette invention est particulièrement avantageuse en terme de dissipation de puissance. En effet, la lecture des cellules mémoire peut être effectuée en appliquant une faible tension. Par ailleurs, lors de l'étape consistant à corriger les pertes d'information générées par l'étape d'assemblage, la tension de correction n'est pas appliquée à l'ensemble des cellules, mais uniquement à celles qui ne sont pas dans un état résistif originel (HRS originel). Il en résulte ainsi un gain en terme de puissance consommée et dissipée et un gain en terme de temps de programmation.

L'invention permet ainsi d'atteindre de grandes densités d'intégration des matrices de cellule mémoire et d'accroître leur robustesse face à un stress thermique.

De préférence, l'étape d'assemblage comprend au moins l'une parmi les étapes suivantes : une étape de brasage, une étape de soudage ou un procédé de type WLCSP (acronyme de Wafer Level Chip Scale Packages dont une traduction en français peut être procédé de réalisation d'un boitier à la taille d'une puce au niveau du substrat).

De préférence, l'étape d'assemblage comprend une étape de brasage ou de soudage du composant sur le support au cours de laquelle les cellules mémoire sont soumises à une température d'au moins 240 °C pendant au moins 10 secondes. De préférence, l'étape d'assemblage comprend l'application d'une température supérieure ou égale à 260 degrés Celsius pendant au moins 10 secondes.

De préférence, l'étape d'assemblage, typiquement par WLCSP, comprend une étape au cours de laquelle les cellules mémoire sont soumises à une température supérieure à 300°C pendant plusieurs minutes. De préférence, l'étape d'assemblage comprend l'application d'une température supérieure ou égale à 300 degrés Celsius pendant au moins 30 minutes. De préférence, l'étape d'assemblage comprend l'application d'une température comprise entre 320°C et 375°C pour une durée comprise entre 40 et 80 minutes.

De manière générale, l'état résistif originel (HRS originel) est l'état obtenu à l'issue du procédé de fabrication des cellules mémoire et qui n'a été altéré par aucun passage de courant de programmation.

Selon un mode de réalisation, si on identifie que la cellule mémoire est dans l'état résistif originel (HRS originel), alors on laisse la cellule mémoire dans l'état résistif originel (HRS originel).

Selon un autre mode de réalisation, si on identifie que la cellule mémoire est dans l'état résistif originel (HRS originel), alors on effectue les étapes suivantes :
- modifier électriquement le matériau diélectrique pour amener la cellule mémoire depuis l'état résistif originel (HRS originel) jusqu'au deuxième état résistif (LRS),
- modifier électriquement le matériau diélectrique pour amener la cellule mémoire depuis le deuxième état résistif (LRS) jusqu'à un troisième état résistif (HRS programmé) dans lequel la cellule mémoire présente une résistance différente, typiquement supérieure à celle de la cellule mémoire dans le deuxième état résistif (LRS).

Avantageusement, l'étape de modification électrique du matériau diélectrique jusqu'à amener la cellule mémoire dans ledit troisième état résistif (HRS programmé) est une opération de RESET. Par exemple, l'étape de modification électrique du matériau diélectrique jusqu'à amener la cellule mémoire dans le troisième état résistif (HRS programmé) consiste à rompre, à l'aide d'une opération de RESET, au moins un chemin conducteur préalablement formé entre les électrodes conductrices.

Avantageusement, dans le troisième état résistif (HRS programmé) la cellule mémoire présente une résistance supérieure à celle de la cellule mémoire dans le deuxième état résistif (LRS) de manière à ce, qu'en fonctionnement, un circuit de lecture puisse identifier si la cellule est dans le deuxième état résistif (LRS) ou dans le troisième état résistif (HRS programmé). Typiquement, le circuit de lecture comprend des moyens permettant d'appliquer une tension d'au moins 50 mV aux bornes de la cellule mémoire et de préférence comprise entre 50 mV et 200 mV.

Avantageusement, dans le troisième état résistif (HRS programmé) la cellule mémoire présente une résistance supérieure d'au moins un facteur deux, à la résistance de la cellule mémoire dans le deuxième état résistif (LRS) et de préférence d'au moins un ordre de grandeur, c'est-à-dire un facteur dix en résistance.

Dans le troisième état résistif (HRS programmé), la cellule mémoire présente une résistance inférieure à celle de la cellule mémoire dans l'état résistif originel (HRS originel). De préférence, la cellule mémoire dans le troisième état résistif (HRS programmé) présente une résistance inférieure d'au moins un facteur deux et de préférence d'au moins un facteur dix à celle de la cellule mémoire dans l'état résistif originel (HRS originel).

Par exemple, l'étape de modification électrique du matériau diélectrique jusqu'à amener la cellule mémoire dans ledit deuxième état résistif (LRS) comprend la reformation dans le matériau diélectrique d'au moins un chemin conducteur entre les électrodes conductrices. Avantageusement, l'étape de modification électrique du matériau diélectrique jusqu'à amener la cellule mémoire dans ledit deuxième état résistif (LRS) est une opération de SET.

Ainsi, l'invention permet de conserver, après assemblage, une différence de résistance identifiable, entre d'une part les cellules mémoire qui avaient été modifiées électriquement avant assemblage et d'autre part celles qui n'avaient pas été modifiées électriquement avant assemblage.

Selon les modes de réalisation, on choisira de modifier ou non, après assemblage l'état résistif des cellules mémoire qui avaient été modifiées électriquement avant assemblage. Ainsi, ces cellules mémoire qui se trouvaient dans le deuxième état résistif (LRS) avant assemblage pourront, par application de la tension de correction après assemblage, soit être toutes ré-amenées dans le deuxième état résistif (LRS) soit être amenées dans le troisième état résistif (HRS programmé).

Comme indiqué précédemment, on pourra également choisir ou non de modifier après assemblage l'état résistif des cellules mémoire qui n'avaient pas été modifiées électriquement avant assemblage. Ainsi, ces cellules mémoire qui se trouvaient dans l'état résistif originel (HRS originel) avant assemblage pourront :
- soit être toutes conservées dans l'état résistif originel (HRS originel),
- soit être toutes amenées dans le troisième état résistif (HRS programmé),
- soit être toutes amenées dans le deuxième état résistif (LRS).

On veillera naturellement à ce qu'après assemblage les cellules laissées dans l'état résistif originel lors de l'assemblage ne présentent pas, après assemblage et après une éventuelle reprogrammation, un état résistif identique à celui des autres cellules.

On pourra donc choisir d'avoir, lors du fonctionnement de la cellule, l'un des couples suivants dans une même matrice de cellules:
- état résistif originel (HRS originel) / deuxième état résistif (LRS). Ce couple a pour avantage de présenter une différence de résistance très forte entre les deux états, ce qui permet une lecture très fiable même avec un dispositif de lecture relativement peu précis.
- état résistif originel (HRS originel) / troisième état résistif (HRS programmé). Ce couple a pour avantage de présenter une différence de résistance très forte entre les deux états
- troisième état résistif (HRS programmé) / deuxième état résistif (LRS).

Selon les modes de réalisation, on choisira de ne pas modifier, avant assemblage l'état résistif des cellules mémoire qui avaient été amenées dans le deuxième état résistif (LRS) depuis l'état résistif originel (HRS originel).

Le couple HRS originel/ LRS présente pour avantage de ne nécessiter qu'une seule programmation des cellules.

De préférence, l'étape d'identification est effectuée sur toutes les cellules mémoire de la matrice.

Avantageusement, ledit intervalle de lecture est compris entre -4 et 4 volts, de préférence entre -0.1 et 0.1 volts, encore plus préférentiellement entre -0.05 et 0.05 volts et encore plus préférentiellement entre 0 et 0.01 volts. Ainsi, les tensions appliquées lors de l'étape d'identifications sont très faibles ce qui entraîne une faible dissipation de puissance.

Avantageusement, les résistances des cellules mémoire de la matrice dans l'état résistif originel (HRS originel) sont comprises dans une première plage de valeurs, les résistances des cellules mémoire dans le deuxième état résistif (LRS) sont comprises dans une deuxième plage de valeurs. En outre, les première et deuxième plages sont disjointes au moins pour des tensions comprises dans ledit intervalle de tensions de lecture. De préférence, les première et deuxième plages présentent un écart d'au moins un ordre de grandeur et de préférence d'au moins deux ordres de grandeur, au moins pour des tensions comprises dans ledit intervalle de tensions de lecture.

De préférence, les résistances des cellules mémoire dans le troisième état résistif (HRS programmé) sont comprises dans une troisième plage de valeurs, les première et troisième plages étant disjointes au moins pour des tensions comprises dans ledit intervalle de lecture. De préférence, les première et troisième plages présentent un écart d'au moins un ordre de grandeur de résistance et de préférence d'au moins deux ordres de grandeur, au moins pour des tensions comprises dans ledit intervalle de tensions de lecture.

De préférence, les deuxième et troisième plages présentent un écart d'au moins un facteur 2 et de préférence d'au moins un facteur dix, au moins pour des tensions dudit intervalle de tensions de lecture.

Avantageusement, identifier si chaque cellule mémoire est dans l'état résistif originel (HRS) comprend : l'application sur chaque cellule mémoire d'une tension comprise dans ledit intervalle de lecture et ; la mesure de l'intensité du courant traversant la cellule mémoire et de préférence le calcul de la résistance de cette cellule dans ledit intervalle de tensions de lecture, pour en déduire si la résistance de cette cellule mémoire est comprise dans la première plage de valeurs.

Si la valeur de courant mesuré permet de déterminer que la résistance de la cellule mémoire n'est pas comprise dans cette première plage de valeurs, on en déduit alors que la cellule mémoire n'est pas dans l'état résistif originel. Elle peut soit se trouver dans l'état LRS soit avoir été involontairement amenée à un état plus résistif (HRS programmé) du fait de l'apport de chaleur lors de l'assemblage.

Le procédé selon l'invention comprend, après l'étape de programmation et avant l'assemblage, au moins un cycle d'étapes sur ladite pluralité de cellules, c'est-à-dire sur les cellules sélectionnées qui ont été amenées avant assemblage au deuxième état résistif (LRS), chaque cycle consistant à :
- modifier électriquement le matériau diélectrique pour amener lesdites cellules mémoire depuis le deuxième état résistif (LRS) jusqu'à un troisième état résistif (HRS programmé) dans lequel les cellules mémoire présentent une résistance supérieure à celle des cellules mémoire dans le deuxième état résistif (LRS), puis
- modifier électriquement le matériau diélectrique pour ramener lesdites cellules au deuxième état résistif (LRS).
De préférence, on effectue plusieurs cycles d'étapes.
Avantageusement, au terme d'au moins un cycle d'étapes on vérifie que les cellules sélectionnées sont dans le deuxième état résistif (LRS), on identifie les cellules sélectionnées qui ne sont pas dans l'état résistif originel (LRS) et on transfert le contenu des cellules identifiées à d'autres cellules mémoire.

De préférence, l'étape d'assemblage du composant contenant ladite matrice avec le support comprend l'assemblage du composant sur une carte imprimée, une carte électronique, un autre composant électronique ou un boîtier.

Selon un exemple, il est décrit un procédé de préprogrammation d'une matrice de cellules mémoire résistives non volatiles, lesdites cellules mémoire comprenant un matériau diélectrique disposé entre deux électrodes conductrices, lesdites cellules mémoire étant initialement dans un état résistif originel (HRS originel) et le matériau diélectrique étant agencé pour être modifié électriquement de manière à amener la cellule mémoire depuis l'état résistif originel (HRS originel) jusqu'à un deuxième état résistif (LRS) dans lequel la résistance de la cellule mémoire est au moins deux fois et de préférence dix fois inférieure à la résistance de la cellule mémoire dans l'état résistif originel (HRS originel), de préférence lorsqu'on lui applique une tension de lecture prise dans un intervalle de lecture, le procédé comprenant les étapes suivantes:
- avant assemblage d'un composant contenant ladite matrice sur un support, programmer la matrice en modifiant électriquement le matériau diélectrique de manière à amener électriquement une pluralité de cellules sélectionnées depuis l'état résistif originel (HRS originel) jusqu'audit deuxième état résistif,
   laisser les autres cellules mémoires, c'est-à-dire les cellules mémoire non sélectionnées, dans leur état résistif originel (HRS originel),
- assembler ladite matrice sur un support, au cours de l'étape d'assemblage les cellules mémoire étant soumises à une température d'au moins 240 °C.

De manière facultative, le procédé selon l'invention comprend au moins l'une quelconque des étapes et caractéristiques suivantes.

Selon un mode de réalisation avantageux mais uniquement optionnel, le procédé comprend également les étapes suivantes effectuées après assemblage du composant contenant ladite matrice sur le support: pour au moins un ensemble de cellules mémoire de la matrice et de préférence pour toutes les cellules mémoire de la matrice : identifier si chaque cellule mémoire est dans l'état résistif originel (HRS) en appliquant sur chaque cellule mémoire une tension comprise dans ledit intervalle de lecture. Si la cellule présente la résistance de l'état résistif originel (HRS originel), en déduire que la cellule était dans l'état résistif originel (HRS originel) après programmation et avant assemblage ; sinon, en déduire que la cellule était dans le deuxième état résistif (LRS originel) après programmation et avant assemblage.

Avantageusement, après assemblage, on peut différencier les cellules dans l'état résistif originel de celles qui ne sont plus dans cet état.

Selon un premier mode de réalisation, si la cellule mémoire n'est pas dans l'état résistif originel (HRS originel), on applique à la cellule mémoire une tension de correction dont l'amplitude est supérieure audit intervalle de lecture de manière à ramener ou à maintenir la cellule mémoire dans ledit deuxième état résistif (LRS).

Ainsi, après lecture de la résistance de chaque cellule, les cellules qui avaient été laissées dans leur état résistif originel (HRS originel) ne seront en rien affectées. Au contraire, les cellules qui ne présentent pas la résistance de l'état résistif originel (HRS originel) font l'objet d'une opération pour qu'elles présentent toutes le même état résistif. Selon ce premier mode de réalisation, cet état résistif commun à toutes les cellules qui avaient été programmées est le deuxième état résistif (LRS).

Dans le cas où cet état résistif commun à toutes les cellules qui avaient été programmées est le deuxième état résistif (LRS), une manière d'expliquer simplement serait de dire que les cellules dans lesquelles on avait déjà formé un filament conducteur et dont le filament avait été partiellement défait sous l'effet de l'apport de chaleur généré par l'étape d'assemblage, se voient ramener dans l'état conducteur (LRS) c'est-à-dire que le filament est reformé. Les cellules qui avaient été rendues conductrices lors de l'étape de programmation et qui avaient conservé l'état conducteur (LRS) malgré l'apport de chaleur de l'étape d'assemblage resteront dans cet état conducteur.

De préférence, l'étape d'application à la cellule mémoire d'une tension supérieure audit intervalle de lecture de manière à maintenir ou à ramener la cellule mémoire dans ledit deuxième état résistif (LRS) comprend l'application d'une tension apte à conserver dans le matériau diélectrique un chemin conducteur entre les électrodes conductrices si ce chemin conducteur est présent ou à reformer dans le matériau diélectrique au moins un chemin conducteur entre les électrodes conductrices. Ainsi, si la cellule mémoire est dans le deuxième état résistif (LRS) après assemblage, la tension de correction n'affecte pas la cellule mémoire qui demeure dans cet état. En revanche, si la cellule mémoire est passée, après l'étape d'assemblage, dans un état résistif qui n'est ni l'état résistif originel, ni le deuxième état résistif, alors la tension de correction ramène la cellule mémoire dans le deuxième état résistif (LRS).

Typiquement, cette étape comprend l'application d'une tension comprise entre 500 mV et 2.5 V, et de préférence comprise entre 1 V et 2 V volts. La polarité de cette tension, négative ou positive est ajustée pour effectivement produire l'opération de SET.

De manière générale, on applique à la cellule mémoire une tension supérieure audit intervalle de lecture afin d'amener la cellule mémoire jusqu'au deuxième état résistif (LRS).

Selon un deuxième mode de réalisation alternatif au premier indiqué ci-dessus, si on identifie que la cellule mémoire n'est pas dans l'état résistif originel (HRS originel), on applique alors à la cellule mémoire une tension supérieure audit intervalle de lecture de manière à amener la cellule mémoire dans un autre état résistif, dit troisième état résistif (HRS programmé) dans lequel la résistance la cellule mémoire présente une résistance que l'on peut différencier de la résistance de la cellule mémoire dans l'état résistif originel (HRS originel) lorsqu'on lui applique une tension prise dans l'intervalle de lecture.

Ainsi, toutes les cellules qui avaient été programmées avant assemblage seront dans l'état HRS programmé après assemblage et l'on pourra les différencier de l'état HRS originel.

De manière préférée mais optionnelle, dans le troisième état résistif (HRS programmé) la cellule mémoire présente une résistance inférieure d'au moins un facteur 2, à la résistance de la cellule mémoire dans l'état résistif originel (HRS originel) et de préférence d'au moins un facteur 10. On peut ainsi aisément différencier les cellules qui avaient été programmées avant assemblage de celles qui ne l'avaient pas été.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1c décrivent brièvement un exemple de mémoire RRAM de type OxRAM et son mode de fonctionnement.
Les FIGURE 2a à 2d illustrent d'autres exemples de mémoires RRAM utilisant un matériau diélectrique et des structures d'électrodes différents.
Les FIGURE 3a à 3c illustrent le procédé de préprogrammation de l'invention.
La FIGURE 4 illustre les différents états résistifs que peut prendre un exemple de cellule mémoire selon l'invention.

Les dessins joints sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Il est précisé que dans le cadre de la présente invention, le terme « sur », « surmonte » ou « sous jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans le cadre de la présente invention, on appelle pré-programmation, une programmation de certaines cellules mémoire au moins qui est effectuée avant assemblage de la matrice sur un support, typiquement au cours d'une opération mettant en jeu une température supérieure ou égale à 200°C.

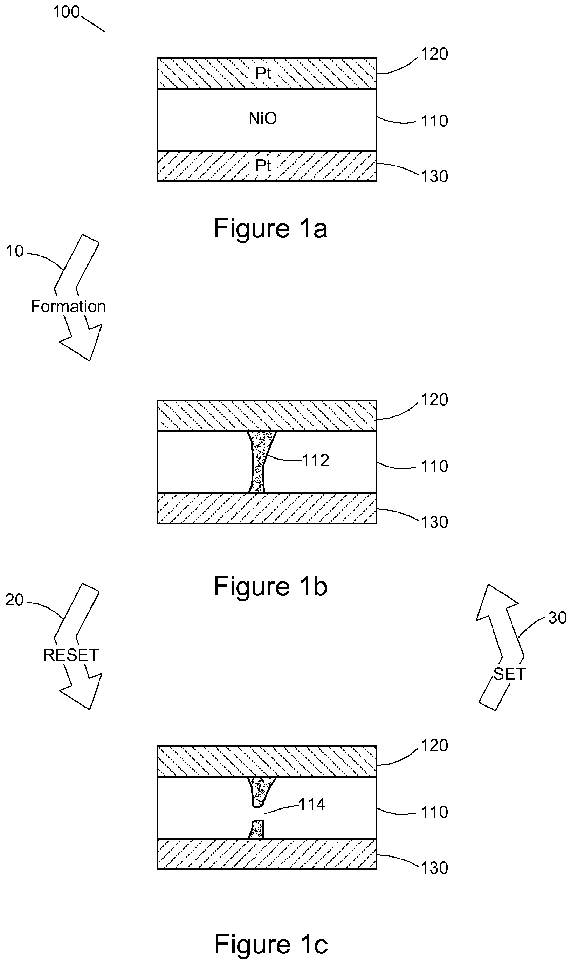

Les **figures 1a, 1b** et **1c** décrivent brièvement un exemple de mémoire résistive (RRAM) de type OxRAM et son mode de fonctionnement. On notera ici que le mode de fonctionnement d'autres mémoires RRAM est similaire. Il s'agit par exemple des mémoires dites CBRAM, acronyme de l'anglais « conductive bridge random-access memory » où, comme le nom le suggère, des « ponts conducteurs » similaires aux filaments décrits sont formés dans un matériau non conducteur. Ces mémoires, et d'autres basées sur les mêmes principes, sont également susceptibles de pouvoir bénéficier de l'invention et l'invention n'est limitative d'aucun des types de mémoires résistives.

On notera ici que l'invention est susceptible de s'appliquer quel que soit le mécanisme mis en oeuvre par la mémoire non volatile considérée pour peu que la résistance de la cellule dans son état initial c'est-à-dire avant tout application d'un courant de programmation soit nettement différentiée de la résistance qu'elle présente après programmation.

La figure 1a illustre la structure d'une cellule mémoire OxRAM 100 où le matériau diélectrique 110 est dans cet exemple de l'oxyde de nickel (NiO) compris entre deux électrodes métalliques, 120 et 130, en platine (Pt).

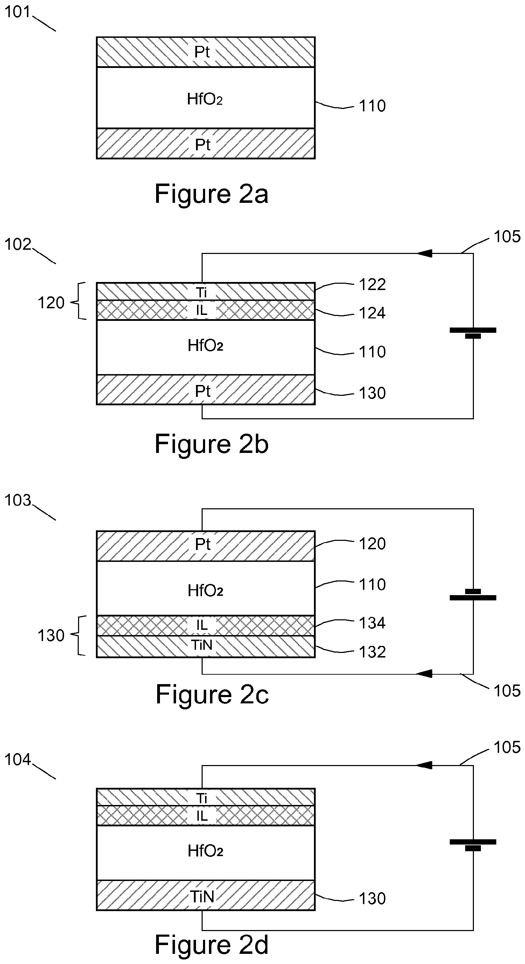

La figure 1b illustre la formation initiale d'un filament conducteur 112 résultant de l'application entre les deux électrodes métalliques d'une tension adéquate dépendant entre autre, comme on va le voir dans la figure 2, de la nature des matériaux employés.

On notera ici que les phénomènes physicochimiques conduisant à la formation d'un filament conducteur 112 ou d'une pluralité de filaments sous l'effet de l'application d'une tension électrique suffisante sur les électrodes, et la nature même du filament ou du chemin conducteur créé dans l'oxyde, restent largement incompris de la communauté scientifique travaillant dans ce domaine. Différents mécanismes ont été avancés pour expliquer la formation des filaments qui incluent la présence de défauts et la migration du métal constituant les électrodes. Toutefois, comme montré sur la figure 1b, on observe bien au cours d'une première étape 10 la formation initiale d'au moins un filament conducteur 112, ou d'un chemin conducteur quel qu'il soit, en appliquant une différence de potentiel suffisante entre les deux électrodes, 120 et 130.

Les cellules mémoire selon l'invention présentent plusieurs états correspondant chacun à un niveau de résistance électrique de la cellule. On peut ainsi dénombrer trois états :
- un état résistif originel, également désigné état non conducteur originel ou état fortement hautement originel. Dans la présente demande de brevet, cet état est également qualifié d'état HRS originel (acronyme de highly resistive state originel en anglais). Cet état est également qualifié de premier état résistif.

On qualifie d'état non conducteur originel l'état obtenu avant toute application de tension visant à modifier la résistivité de la cellule mémoire. Cet état originel est obtenu suite à la formation de la couche diélectrique et des électrodes. Avantageusement, cet état originel est obtenu à l'issue des phases ultimes du procédé de fabrication et qui consistent essentiellement à l'interconnexion des composants élémentaires entre eux, typiquement les cellules mémoire, à la carte, et vers l'extérieur, à l'aide de plages et de connexions métalliques généralement définies par photolithographie. Ces phases ultimes sont généralement qualifiées de BEOL, acronyme de l'anglais « back-end of line » c'est-à-dire étapes de « fin de ligne » de fabrication. Généralement, au cours de ces étapes de BEOL les cellules mémoires doivent supporter des températures allant jusqu'à 400°C, typiquement, pendant quelques minutes et jusqu'à une dizaine de minutes. De manière avantageuse, l'étape de programmation de la matrice pour amener électriquement un ensemble de cellules sélectionnées depuis l'état non conducteur originel à l'état conducteur ou moins résistif (LRS) est effectuée après BEOL. De manière également avantageuse, au cours de l'étape d'assemblage, on applique aux cellules mémoire un stress thermique inférieur à celui appliqué lors des étapes de BEOL, typiquement, on applique des températures inférieures à celles appliquées lors du BEOL.

Dans cet état, l'information codée en binaire par la cellule est par exemple un « 0 ».
- un état conducteur ou peu résistif, également désigné état à faible résistance.
Cet état est également qualifié de deuxième état résistif. Par souci de concision et de clarté, dans la présente demande de brevet, cet état est également qualifié d'état LRS. LRS étant l'acronyme de low resistive state en anglais, signifiant état à faible résistance. Cet état LRS est obtenu en appliquant une tension à la cellule mémoire se trouvant dans l'état HRS originel. Cet état est donc obtenu directement à partir de l'état résistif originel (HRS originel).

Une explication de l'augmentation de la conductivité dans cet état LRS repose sur la formation des filaments. De manière plus générale, on qualifie d'état conducteur un état dans lequel la cellule mémoire présente une résistance inférieure à la résistance qu'elle présente dans un état non conducteur ou résistif. A titre d'exemple non limitatif, on peut qualifier d'état conducteur ou électriquement peu résistif un état dans lequel la résistance de la cellule est inférieure ou égale à 1,5 kilo ohms et de préférence inférieure à 1000 ohms. Ces valeurs de résistance peuvent largement varier en fonction des applications et/ou de la structure et de la composition de la cellule mémoire.

Dans cet état, l'information codée en binaire par la cellule dans l'état LRS sera par exemple un « 1 » si l'information codée par la cellule dans l'état HRS originel est un « 0 ». Inversement, l'information codée en binaire par la cellule dans l'état LRS sera un « 0 » si l'information codée par la cellule dans l'état HRS originel est un « 1 ».
- un état résistif programmé ou état fortement résistif programmé ou état à haute résistance programmé. Cet état est également qualifié de troisième état résistif. Par souci de concision, dans la présente demande de brevet, cet état est également qualifié d'état « HRS programmé ». Cet état HRS programmé est obtenu en appliquant une tension à la cellule mémoire se trouvant dans l'état LRS. La résistance de la cellule mémoire dans cet état résistif programmé est néanmoins toujours inférieure à la résistance de la cellule dans l'état hautement résistif originel (HRS originel).

On qualifie usuellement de RESET l'opération qui consiste à amener la cellule mémoire depuis l'état LRS à l'état HRS programmé. En fonction des applications, on peut considérer qu'une cellule mémoire dans l'état HRS programmé porte l'information « 0 » si la cellule dans l'état LRS porte l'information « 1 » ou inversement, que la cellule mémoire dans l'état HRS programmé porte l'information « 1 » si la cellule dans l'état LRS porte l'information « 0 ».

Les états HRS originel, LRS et HRS programmé présentent des résistances différentes. Plus précisément, la résistance des cellules dans l'état HRS originel doit être clairement différentiable de la résistance des cellules dans l'état HRS programmé ou dans l'état LRS et ceci pour toutes les cellules du dispositif.

Typiquement, l'invention s'applique à toutes les cellules mémoires pour lesquelles la distribution des résistances dans les états HRS originel ne chevauche pas la distribution des résistances dans les états HRS programmé ou LRS. Ainsi un écart de résistance doit être présent entre ces distributions. De préférence cet écart de résistance est d'au moins un facteur 2, encore plus préférentiellement d'au moins un facteur 10 et encore plus préférentiellement d'au moins un facteur 100.

En fonction du type de mémoire OxRAM considéré, dont la figure 1 n'est qu'un exemple, on observe deux modes de fonctionnement différents :
- L'un est dit unipolaire ou non polarisé. C'est-à-dire que les opérations de formation ou de reformation d'un filament conducteur ou SET, et de rupture du filament ou RESET, ne dépendent pas de la polarité de la tension appliquée.
- L'autre est dit bipolaire ou polarisé. Les opérations de SET et de RESET se font avec des polarités opposées.

Quel que soit le mode de fonctionnement, la figure 1c illustre la rupture 114 du filament qui est obtenue à l'issue d'une opération 20 de RESET qui place ou replace la cellule mémoire dans un état à haute résistance (HRS programmé). La reformation 112 du filament est obtenue à l'issue d'une opération 30 de SET. La cellule mémoire est alors à nouveau dans un état à faible résistance (LRS).

Les **figures 2a** à **2d** illustrent d'autres exemples de mémoires RRAM utilisant un matériau diélectrique et des structures d'électrodes différents. L'invention n'est pas limitée à ces autres exemples et s'étend à de nombreuses autres structures de cellule mémoire vérifiant les conditions mentionnées ci-dessous pour effectuer les opérations de changement de résistivité.

La figure 2a montre une première structure 101 similaire à celle de la figure 1a dans laquelle le matériau diélectrique 110 est alors constitué d'oxyde d'hafnium (HfO2). On notera dans ce cas qu'il y a un consensus de la communauté scientifique pour conclure que l'état conducteur d'une cellule mémoire faite d'oxyde d'hafnium est obtenu en raison de la formation de filaments faits de l'agrégation de lacunes en oxygène.

Le HfO2 est déposé par ALD, acronyme de l'anglais « atomic layer déposition » c'est-à-dire « dépôt en couches atomiques » dans un appareillage spécialisé avec les conditions suivantes:
- température de dépôt : 350°C ;
- pression : 1 Torr ;
- gaz précurseurs : tétrachlorure de hafnium (HfCl4) et oxyde d'hafnium (HfO2) en phase vapeur, envoyés par cycles séparés sur la tranche. Un cycle complet se compose de: un pulse de HfCl4, une purge d'azote (N2), un pulse d'eau (H2O), 1 purge d'azote
- Pour faire croître 10 nm de HfO2 il faut 180 cycles.

La liste des matériaux dans lesquels des filaments conducteurs sont susceptibles de se développer comprend potentiellement, outre les oxydes de nickel et d'hafnium mentionnés ci-dessus, tous les oxydes qui fonctionnent selon le même modèle, c'est-à-dire à partir de la formation de lacunes en oxygène.

Ces figures 2a-2d laissent clairement apparaître que le matériau diélectrique 110 est disposé sur le chemin de passage du courant. Le courant passant d'une électrode 120, 130 à l'autre doit nécessairement traverser ce matériau diélectrique 110. Comme illustré sur ces figures, le matériau diélectrique 110 est au contact de chacune des deux électrodes 120, 130. Aucun autre matériau n'est prévu entre le matériau diélectrique 110 et les deux électrodes 120, 130 lors de la fabrication de la cellule.

La figure 2b illustre une deuxième structure 102 de cellule mémoire dans laquelle l'électrode supérieure 120 est différente de l'électrode inférieure 130. En particulier, l'électrode supérieure comprend deux couches dont l'une 122 est faite de titane (Ti). L'autre constitue une couche d'interface 124 avec l'oxyde d'hafnium 110. Il s'agit d'une couche sous-stoichiométrique en oxygène de HfO2. Elle est désignée par l'acronyme «IL» de l'anglais « interfacial layer». La couche 124 se forme naturellement à cause du titane (Ti) de la couche 122 qui absorbe l'oxygène de la couche 110 faite de HfO2. La couche 124 n'est pas déposée intentionnellement. Seule la couche 122 constitue à proprement parler l'électrode supérieure dont une partie du titane va se fondre avec le HfO2 selon le phénomène décrit ci-dessus. Dans la structure de la figure 2b l'électrode inférieure 130 est comme précédemment en platine. Dans la figure 2b, et pour les structures asymétriques suivantes, les tensions positives sont appliquées comme indiqué par la référence 105 pour l'opération 10 de formation et 30 de SET.

La figure 2c illustre une troisième structure 103 de cellule mémoire dans laquelle c'est l'électrode supérieure 120 qui reste en platine. L'électrode inférieure 130 comprend dans ce cas deux couches. La couche 134 est identique à la couche d'interface (IL) décrite ci-dessus. La couche 132 est faite de nitrure de titane (TiN).

La figure 2d illustre une quatrième structure 104 de cellule mémoire qui est similaire à la structure 102 décrite dans la figure 2b. La différence étant que l'électrode inférieure 130 est alors constituée de nitrure de titane (TiN) en remplacement du platine.

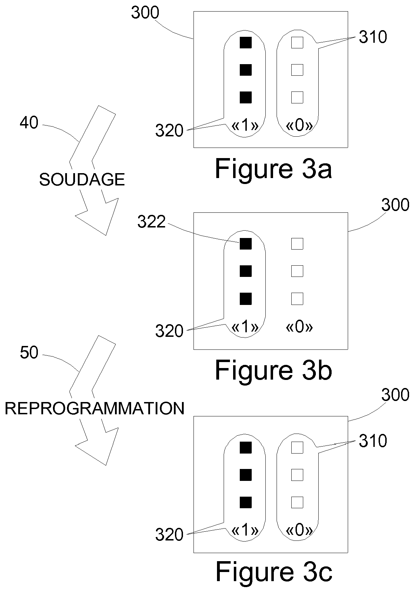

Les **figures 3a, 3b** et 3**c** illustrent le procédé de préprogrammation de l'invention qui peut s'appliquer sur des matrices de cellules mémoires du type de celles décrites dans les figures précédentes.

La figure 3a illustre l'étape de préprogrammation qui s'effectue sur chaque matrice mémoire 300 typiquement contenue dans une puce électronique et dans laquelle on désire stocker des informations. Dans le contexte de l'invention ce stockage se fait avantageusement, pour les raisons exposées dans le chapitre sur l'état de la technique, en fin de cycle de fabrication des puces, avant leur montage sur un circuit imprimé constituant tout ou partie d'un système embarqué, où elles devront alors subir les températures engendrées par le soudage par refusion des composants. La préprogrammation électrique en fin de cycle de programmation peut se faire avec les moyens conventionnels développés par l'industrie de la microélectronique. Notamment, la préprogrammation pourra se faire à l'aide d'un outillage électromécanique adéquat sur l'ensemble des puces contenues sur une tranche avant découpage de cette dernière ou sur chaque puce individuellement après découpage.

Quel que soit le stade de fabrication où la préprogrammation est effectuée et quels que soient les moyens employés l'invention prévoit que l'information préprogrammée l'est sous deux formes :
- un ensemble de cellules mémoire 310 est laissé dans l'état originel, celui résultant du cycle de fabrication. On n'applique sur ces cellules aucun signal électrique susceptible d'en modifier la structure physicochimique. Notamment, les tensions éventuellement appliquées restent toujours bien inférieures aux tensions qu'il faudrait appliquer pour faire passer la cellule dans l'état LRS c'est-à-dire pour obtenir la formation initiale 10 des filaments conducteurs. Les cellules de cet ensemble, dont le matériau est laissé dans son état originel « tel que déposé » sont alors dans un état à très forte résistance quasi non conducteur. On notera ici que cet état résistif originel est toujours nettement plus élevé que l'état HRS programmé, c'est-à-dire obtenu par une opération de RESET où l'on vient rompre électriquement les filaments. Une caractérisation de ces états résistifs est discutée en figure 4.
- un autre ensemble de cellules mémoire 320, généralement l'ensemble complémentaire de la matrice mémoire 300 que l'on désire préprogrammer, est choisi sur lequel on va procéder individuellement, dans chacune des cellules mémoire sélectionnées, à la formation électrique des filaments conducteurs comme expliqué précédemment. Ces cellules mémoires seront alors mises dans un état à faible résistance (LRS). On notera qu'il est possible, voire fréquent, que toutes les cellules mémoires d'une matrice mémoire d'une puce que l'on désire préprogrammer pour une application particulière ne soient pas en pratique utilisées. En fonction de mises en oeuvre spécifiques de l'invention les cellules mémoires inutilisées par l'application pourront servir de cellules d'essai comme déjà mentionné dans la figure précédente. Elles pourront tout aussi bien être laissées dans l'état originel (HRS originel) ou au contraire placées volontairement dans l'état LRS.

Ici il convient de remarquer que pour désigner l'état binaire que peut prendre une cellule mémoire, les chiffres « 0 » et « 1 » sont très communément employés. Dans le domaine de l'invention, on associe généralement le « 0 » à l'état HRS programmé obtenu électriquement à l'issue d'une opération de RESET où à l'état HRS originel à très forte résistance mentionné ci-dessus. L'état « 0 » de la cellule à forte, voire très forte, résistance est reconnu par un circuit de lecture périphérique (non représenté) de la matrice sous la forme d'une absence de courant ou d'un courant restant suffisamment faible pour qu'il ne soit pas détectable par celui-ci. Au contraire, dans l'état LRS le circuit de lecture peut détecter le passage d'un courant plus important et on associe donc généralement cet état au chiffre « 1 ». Cette convention, la plus employée, est aussi utilisée dans la description qui suit de cette invention. La convention contraire pourrait cependant tout aussi bien être utilisée. Ainsi, dans le langage courant partagé par tous ceux qui travaillent dans ce domaine, l'étape de préprogrammation consiste à programmer des « 1 », c'est-à-dire des valeurs faibles de résistance, dans un ensemble de cellules mémoire qui est spécifique à une application donnée. Les autres cellules étant laissées dans leur état originel à très forte résistance, c'est-à-dire dans l'état « 0 ».

La figure 3b illustre l'effet sur les matrices mémoires 300 d'un apport de chaleur. Comme indiqué précédemment, cet apport de chaleur est typiquement provoqué par une opération d'assemblage du composant comportant la matrice de cellules mémoire sur un support tel qu'une carte électronique, un boîtier encapsulant le composant ou sur un autre composant. Cette opération d'assemblage comprend par exemple une étape de soudage par refusion 40 habituellement désigné « solder reflow » en anglais. Typiquement, lors de cette opération d'assemblage, les cellules mémoire sont soumises à une température comprise entre 150°C et 300°C et le plus souvent comprise entre 240°C et 300°C.

Comme on l'a vu l'état « 1 » préprogrammé (LRS) est thermiquement instable. Certaines des cellules 322 au moins, sinon toutes celles de l'ensemble 320, sont susceptibles d'être affectées par une température qui atteint comme on l'a vu 260°C, typiquement pendant une période de temps de l'ordre de 2 minutes. Les filaments 112 qui ont été formés pour la préprogrammation seront alors partiellement défaits 114, comme après une opération de RESET. Ces cellules passent donc, d'une manière non souhaitée, d'un état LRS à un état HRS programmé.

La figure 3c illustre le résultat d'un mode préféré mais optionnel de l'invention qui prévoit qu'après assemblage, et donc après l'étape d'apport d'une quantité importante de chaleur (soudage par exemple) des puces préprogrammées sur leurs circuits imprimés, toutes les cellules mémoires préprogrammées (c'est à dire les cellules qui ne se trouvent plus dans l'état HRS originel après assemblage) contenues dans ces puces sont à nouveau « reprogrammées ». Cette étape de reprogrammation est avantageuse mais non obligatoire dans le cadre de l'invention.

L'étape de reprogrammation 50, consiste à restaurer les états binaires « 1 », thermiquement instables, qui ont pu être affectés par l'opération d'assemblage. Elle se fait sur la base d'une mesure préalable de la résistance de chaque cellule. La mesure de la résistance de la cellule est effectuée à « faible champ » en appliquant des tensions modérées qui ne risquent pas d'en altérer la valeur. Cette tension peut être qualifiée de tension de lecture ou de tension de détection.

Cette tension de lecture est prise parmi un intervalle de tensions de lecture. L'intervalle de tensions de lecture comprend toutes les tensions, positives ou négatives, pour lesquelles l'amplitude est inférieure à une amplitude qui modifierait la résistance de la cellule. De préférence, cet intervalle est défini de manière à prévoir un coefficient de sécurité en étant suffisamment éloigné de l'amplitude minimale qui modifie la résistance de la cellule mémoire.

Comme illustré dans la figure 4 ci-après, la mesure se fait typiquement en appliquant quelques centaines de millivolts. Typiquement, la tension appliquée à chacune des cellules mémoire pour identifier si elle se trouve ou non dans l'état HRS originel est comprise entre 10 mV et 200 mV volts et plus précisément entre 50 mV et 100 mV. Ces chiffres sont à considérer en valeur absolue, puisque l'on peut appliquer des tensions positives ou négatives. Comme décrit plus bas en référence, à figure 4, l'intervalle de tensions de lecture est de préférence centré sur 0 et comporte des tensions positives et négatives. Dans ces conditions on peut retrouver les cellules qui ont été programmées à « 1 » avant soudage par refusion en remarquant que celles qui avaient été laissées dans leur état originel ont une valeur de résistance, non seulement nettement plus élevée que celles dont le filament n'a pas été rompu et qui sont restées dans l'état LRS, mais aussi plus élevée que celles dont le filament a été rompu et qui sont repassées dans l'état HRS programmé comme après une opération de RESET. Sur la base de cette remarque, après lecture de la résistance de chaque cellule, on peut donc restaurer électriquement les états « 1 » préprogrammés à l'aide d'une opération de SET. Cette restauration se fait donc sur toutes les cellules dont on détecte que la résistance n'est pas celle des cellules qui ont été laissées dans leur état originel et où le matériau est resté « tel que déposé ». Cette tension appliquée pour maintenir ou pour ramener les cellules dans l'état LRS peut être qualifiée de tension de correction ou de tension de reprogrammation de l'état LRS.

On notera que cette étape de reprogrammation 50, qui s'effectue une seule fois après assemblage, ne nécessite en rien de connaître la préprogrammation spécifique qui aura été utilisée en fin de ligne de fabrication pour personnaliser la matrice 300. En effet, cette étape caractéristique de l'invention prévoit que toutes les cellules mémoires d'une matrice mémoire préprogrammée sont systématiquement parcourues pour être reprogrammées en cas de besoin (c'est-à-dire si elles ne se trouvent plus dans l'état HRS originel après assemblage) comme décrit ci-dessus. Cette étape de lecture met en jeu un courant de faible valeur qui dissipe donc peu de puissance.

En ce qui concerne les cellules qui ont été laissées dans leur état originel, c'est-à-dire l'ensemble de cellules 310, deux options sont possibles lors de l'étape de reprogrammation :
- une première option consiste à les laisser dans leur état originel à très forte résistance (HRS originel). Le circuit fonctionnel de lecture (non représenté), qui aura été ajusté pour ne pas détecter fonctionnellement un courant faible correspondant à l'état HRS programmé, ne détectera pas à fortiori un courant encore plus faible résultant de l'état résistif originel.
- une seconde option consiste à y former électriquement 10 un filament puis à effectuer une opération de RESET 20 afin de le rompre et de placer la cellule dans son état HRS programmé. Dans ces conditions, l'ensemble des cellules de la matrice est à l'issue de l'étape de reprogrammation 50 dans des états résistifs que l'on peut obtenir avec les opérations électriques normalement effectuées par les circuits périphériques de lecture et d'écriture (non représentés). Il n'est donc pas nécessaire dans ce cas de prévoir, lors de l'utilisation fonctionnelle du dispositif, une opération spécifique d'écriture des cellules qui auraient été laissées dans leur état originel et pour lesquelles il faudrait d'abord procéder à la formation d'un filament.

Le procédé de préprogrammation décrit ci-dessus s'applique sans restriction aux deux types de mémoires OxRAM mentionnés précédemment celles dites polarisées ou bipolaires et celle dites non polarisées.

De manière optionnelle et avantageuse, on remarquera que les cellules préprogrammées à « 1 » avant application du stress thermique (correspondant typiquement à une étape de soudage) pourront l'être plusieurs fois en effectuant des cycles de RESET et SET afin d'être sûr qu'elles sont bien fonctionnelles. Ces séquences d'opérations de SET et de RESET ont également pour but de stabiliser le filament conducteur qui est formé. Avantageusement, les cellules qui s'avéreraient alors être hors spécification, ayant par exemple des valeurs de SET particulièrement élevées ou dispersées, pourront être déclarées non fonctionnelles. Elles seront non utilisées et remplacées par d'autres cellules fonctionnelles. Leur contenu sera alors transféré en mettant en œuvre les techniques de redondance développées pour d'autres types de mémoires comme celles dites FLASH qui peuvent fonctionner avec des cellules individuelles, des secteurs voire des pages non fonctionnels.

La **figure 4** illustre les différents états résistifs que peut prendre un exemple de cellule mémoire 401 selon l'invention. Le diagramme 400 indique en ordonnée le courant traversant la cellule en fonction de la tension appliquée à ses bornes.

Comme mentionné précédemment, lors de l'étape de reprogrammation, la mesure de la résistance de la cellule se fait à « faible champ » en appliquant des tensions modérées qui ne risquent pas d'en altérer la valeur. Typiquement, à quelques centaines de millivolts 414 autour de zéro volt. Dans ces conditions, on peut retrouver les cellules qui ont été programmées avant l'étape d'assemblage au cours de laquelle un stress thermique est appliqué à la cellule mémoire (e.g., soudage par refusion). En effet les cellules mémoire qui ont été laissées dans leur état originel (HRS originel) ont une valeur de résistance qui est de plusieurs ordres de grandeur supérieurs à la résistance de SET voire même à celle de RESET puisque le dispositif ne peut jamais retrouver électriquement son état résistif originel (HRS originel) tel qu'obtenu en fin de cycle de fabrication.

Comme on peut le voir sur la courbe 410 du diagramme 400, qui montre en ordonnée l'évolution du courant lors de la formation initiale des filaments, les courants mesurés à faible tension (entre 0 et + ou - 0.2V par exemple) sont extrêmement faibles 412, de l'ordre de 10⁻¹³ à 10⁻¹² ampère. Il s'agit en pratique d'un état non conducteur très fortement résistif.

Après une première formation de filaments, les opérations de RESET et de SET décrites précédemment vont faire évoluer le dispositif dans une gamme de valeurs plus faibles qui est illustrée par les courbes 420 et 430 correspondant à un fonctionnement polarisé du dispositif considéré dans lequel la formation des filaments se fait avec une tension positive, une opération de RESET s'effectue avec une tension négative et une opération de SET avec une tension positive.

Les courants les plus faibles mesurés à faible tension sont alors toujours supérieurs à 10⁻¹⁰ ampère 422 c'est-à-dire nettement plus élevés que ceux correspondant à l'état originel de la cellule.

Ainsi, une cellule mémoire qui aura été préprogrammée avant soudage, peut avoir perdu son état LRS qui est comme on l'a vu thermiquement instable. Toutefois, son état qui correspond alors à l'état HRS programmé 422 peut encore être nettement différencié de l'état originel 412.

Sur l'exemple illustré, pour des tensions comprises entre -0.2V et 0.2V, l'écart de courant entre d'une part les cellules dans leur état HRS originel et dans d'autre part les cellules dans leur état HRS programmé ou LRS est toujours supérieur à trois ordres de grandeur. Cet écart est illustré par la flèche de la figure 4. En effet, pour les cellules dans l'état HRS programmé ou LRS, le courant le plus faible est obtenu à 0.2V et est égal à 10⁻⁹ ampère 422 alors que pour les cellules dans l'état HRS originel, le courant le plus élevé, obtenu à 0.2V, est égal à 10⁻¹² ampère 412.

De manière plus générale, l'ensemble des cellules dans l'état LRS 420 et dans l'état HRS programmé 430 présentent une résistance (ou sont traversées par un courant) significativement différente de l'ensemble des cellules se trouvant dans l'état HRS originel 410. Ainsi un écart sépare la distribution des cellules dans l'état LRS ou dans l'état HRS programmé de la distribution des cellules se trouvant dans l'état HRS originel.

On peut donc ainsi retrouver l'état de préprogrammation du dispositif quand bien même des cellules auraient perdues leur état LRS préprogrammé en raison du stress thermique subi.

La description qui précède décrit plus particulièrement des modes de réalisation dans lesquels l'étape d'assemblage est effectuée par soudage ou par brasage. L'invention s'étend également aux modes de réalisation dans lesquels l'assemblage du composant contenant la matrice de cellules mémoire sur un support est effectué par la méthode dite WLCSP (Wafer Level Chip Scale Packages).

Cette technique d'assemblage a été développée par l'industrie de la microélectronique pour permettre l'assemblage des composants constituant un système embarqué sur un ou plusieurs circuits imprimés. Cette technique repose sur le dépôt, sur le composant à assembler, d'une couche de matériau polymère photo-définissable par exemple un matériau polyimide, c'est-à-dire un matériau polymère contenant un ou plusieurs groupes imide dans sa chaine principale, ou le polybenzobisoxazole également appelé PBO. Ces matériaux étant photo-définissables, la couche ainsi déposée pourra être gravée par exposition à un stimulus lumineux approprié suivi par un développement. Une bille métallique peut alors être déposée dans la cavité tout juste obtenue. Cette bille est responsable des contacts mécanique et électriques entre le composant à assembler et le ou les circuit(s) imprimé(s) correspondant(s).

Dans certains cas, le dépôt de la bille métallique est remplacé par le dépôt d'une couche métallique, par exemple en Cuivre, appelée ReDistribution Layer ou RDL, qui est gravée. Cette couche RDL est alors encapsulée par un matériau polymère photo-définissable qui est à son tour gravé par exposition à un stimulus lumineux approprié et développement. Une bille métallique, responsable des contacts mécanique et électriques entre le composant à assembler et le ou les circuit(s) imprimé(s) correspondant(s), est alors déposée dans la cavité tout juste obtenue.

Dans certains cas, le dépôt de la bille métallique est précédé de l'obtention d'une couche métallique, appelée UBM pour Under Bump metallurgy, en Cuivre ou à base de Nickel (voir Figures ci-dessus).

Bien souvent, la couche ou les couches de matériau polymère doivent être obtenues en suivant un procédé incluant des étapes de recuit à haute température. Nous proposons ci-dessous un exemple des principales étapes nécessaires à l'obtention d'une couche de matériau polymère pouvant être utilisée lors des techniques d'assemblage décrites précédemment :
- Préparation du substrat : T° 80°C-200°C - Durée : 60-240 secondes (s)
- Recuit doux (soft bake) : T° 120°C - Durée : 180 s
- Cure sous Azote (HD8820) :
   ∘ Montée en température : 25°C -> 150°C avec une pente de 4°C/min
   ∘ Montée en température: 150°C -> 320°C avec une pente de 2,5°C/min
   ∘ Plateau de température: 320°C pendant 1 heure
   ∘ Retour graduel à température ambiante
Les indications ci-dessous concernent un autre exemple de cure sous Azote (HD-4100) :
∘ Montée en température : 25°C -> 200°C avec une pente de 10°C/min
∘ Attente à 200°C pendant 30 min
∘ Montée en température : 200°C → 375°C avec une pente de 10°C/min
∘ Plateau de température: 375°C pendant 1 heure
∘ Retour graduel à température ambiante

Ainsi, ces procédés comprennent au moins une étape à une température comprise supérieure à 240°C, souvent supérieure à 300°C et le plus souvent entre 320°C et 375°C pour une durée de plusieurs dizaines de minutes, typiquement 60 minutes.

L'invention permet retrouver après cette étape à très haute température les données sauvegardées avant assemblage.

La présente invention peut ainsi s'appliquer à toutes les cellules mémoire pour lesquels la différence de courant mesuré à faible tension présente entre, d'une part les cellules dans leur état HRS originel et d'autre part les cellules dans leur état HRS programmé ou dans leur état LRS, un écart suffisant pour être détecté sans ambiguïté. De préférence, cet écart de courant est d'au moins un facteur 2 en courant (ou résistance) mesurée. De manière encore plus préférée, cet écart de courant est d'au moins un facteur 10. De manière encore plus préférée, cet écart de courant est d'au moins un facteur 100.

Autrement dit, l'invention s'applique à toutes les matrices de cellules mémoire réalisées avec un procédé technologique, des matériaux et des conditions de fabrication qui permettent d'obtenir de façon reproductible et stable sur l'ensemble des cellules produites par une chaîne de fabrication, une distribution statistique des résistances des cellules dans leur état HRS originel telle qu'elle ne chevauche pas la distribution des cellules dans leur état HRS programmé ou dans leur état LRS. Ou, en d'autres termes, que les distributions de ces paramètres, HRS originel d'une part et HRS programmé ou LRS d'autre part, puissent être considérées comme étant disjointes pour chaque matrice mémoire produite.

L'invention n'est pas limitée aux modes de réalisation précédemment décrits mais s'étend à tous les modes de réalisation couverts par la portée des revendications.

## Revendications

1. Procédé de préprogrammation d'une matrice (300) de cellules mémoire résistives non volatiles, lesdites cellules mémoire (310, 320) comprenant un matériau diélectrique (110) disposé entre deux électrodes conductrices (120, 130), le matériau diélectrique (110) étant un oxyde et étant au contact de chacune des deux électrodes conductrices (120, 130), lesdites cellules mémoire (310, 320) étant initialement dans un état résistif originel (HRS originel) et le matériau diélectrique (110) étant apte à être modifié électriquement de manière à amener la cellule mémoire depuis l'état résistif originel (HRS originel) jusqu'à au moins un autre état résistif (LRS) dans lequel la résistance de la cellule mémoire est au moins deux fois et de préférence au moins dix fois inférieure à la résistance de la cellule mémoire dans l'état résistif originel (HRS originel), au moins pour un intervalle de tensions de lecture, le procédé comprenant les étapes suivantes :
- avant assemblage d'un composant contenant ladite matrice sur un support,
programmer la matrice en amenant électriquement une pluralité de cellules (320) depuis l'état résistif originel (HRS originel) jusqu'audit autre état résistif (LRS), ledit autre état résistif étant un deuxième état résistif, laisser les autres cellules mémoires (310) dans leur état résistif originel (HRS originel);
- assembler ladite matrice sur un support,
**caractérisé en ce qu'**au cours de l'étape d'assemblage les cellules mémoire sont soumises à une température d'au moins 240°C, et
**en ce que** le procédé comprend en outre, après l'étape de programmation et avant l'assemblage, au moins un cycle d'étapes effectuées sur les cellules de ladite pluralité de cellules amenées audit deuxième état résistif, chaque cycle comprenant :
- une modification électrique du matériau diélectrique pour amener lesdites cellules mémoire depuis ledit deuxième état résistif jusqu'à un troisième état résistif (HRS programmé) dans lequel les cellules mémoire présentent une résistance supérieure à celle des cellules mémoire dans ledit deuxième état résistif (LRS), puis
- une modification électrique du matériau diélectrique pour ramener lesdites cellules audit deuxième état résistif.

2. Procédé selon la revendication précédente, dans lequel le procédé comprend l'étape suivante d'identification effectuée après assemblage du composant contenant ladite matrice sur le support:
- pour au moins un ensemble de cellules mémoire de la matrice, appliquer une tension prise dans l'intervalle de lecture ;
- si la cellule présente la résistance de l'état résistif originel (HRS originel), en déduire que la cellule était dans l'état résistif originel (HRS originel) après programmation et avant assemblage ; sinon, en déduire que la cellule n'était pas dans l'état résistif originel (HRS originel) après programmation et avant assemblage.

3. Procédé selon l'une quelconque des revendications précédentes dans lequel ledit autre état résistif est directement obtenu par application d'une tension depuis l'état résistif originel (HRS originel).

4. Procédé selon la revendication 2 et la revendication 3, dans lequel le procédé comprend les étapes suivantes, effectuées après assemblage du composant contenant ladite matrice sur le support:
- identifier si la cellule mémoire est dans l'état résistif originel (HRS originel) (412) ;
- si la cellule mémoire n'est pas dans l'état résistif originel (HRS originel) (412), appliquer à la cellule mémoire une tension supérieure audit intervalle de lecture de manière à ramener ou à maintenir la cellule mémoire dans ledit deuxième état résistif (LRS).

5. Procédé selon la revendication 2, comprenant en outre les étapes suivantes, effectuées après assemblage du composant contenant ladite matrice sur le support:
- identifier si la cellule mémoire est dans l'état résistif originel (HRS originel) (412) ;
- si la cellule mémoire n'est pas dans l'état résistif originel (HRS originel) (412), appliquer à la cellule mémoire une tension dont l'amplitude est supérieure audit intervalle de lecture de manière à amener la cellule mémoire dans le troisième état résistif (HRS programmé) dans lequel la cellule mémoire présente une résistance que l'on peut différencier de la résistance de la cellule mémoire dans l'état résistif originel (HRS originel) par application d'une tension prise dans l'intervalle de lecture.

6. Procédé selon l'une quelconque des revendications précédentes 2 à 5, dans lequel si on déduit que la cellule mémoire est dans l'état résistif originel (HRS originel) (412), alors on laisse la cellule mémoire dans l'état résistif originel (HRS originel).

7. Procédé selon les revendications 2 et 3, dans lequel, si on identifie que la cellule mémoire est dans l'état résistif originel (HRS originel) (412), alors on effectue les étapes suivantes :
- modifier électriquement le matériau diélectrique pour amener la cellule mémoire depuis l'état résistif originel (HRS originel) jusqu'au deuxième état résistif (LRS),
- modifier électriquement le matériau diélectrique pour amener la cellule mémoire depuis le deuxième état résistif (LRS) jusqu'au troisième état résistif (HRS programmé) dans lequel la cellule mémoire présente une résistance différente de celle de la cellule mémoire dans le deuxième état résistif (LRS),
et dans lequel l'étape de modification électrique du matériau diélectrique jusqu'à amener la cellule mémoire dans ledit troisième état résistif (HRS programmé) est une opération de RESET.

8. Procédé selon la revendication précédente, dans lequel, dans le troisième état résistif (HRS programmé) la cellule mémoire présente une résistance supérieure à celle de la cellule mémoire dans le deuxième état résistif (LRS) de manière à ce qu'un circuit de lecture puisse identifier si la cellule est dans le deuxième état résistif (LRS) ou dans le troisième état résistif (HRS programmé), de préférence, dans le troisième état résistif (HRS programmé) la cellule mémoire présente une résistance supérieure d'au moins un facteur 2, et de préférence d'au moins un facteur 10, à la résistance de la cellule mémoire dans le deuxième état résistif (LRS).

9. Procédé selon l'une quelconque des revendications 2 à 8, dans lequel l'étape d'identification est effectuée sur toutes les cellules mémoire de la matrice.

10. Procédé selon l'une quelconque des revendications précédentes, dans lequel les résistances des cellules mémoire de la matrice dans l'état résistif originel (HRS originel) sont comprises dans une première plage de valeurs, les résistances des cellules mémoire dans le deuxième état résistif (LRS) sont comprises dans une deuxième plage de valeurs et dans lequel les première et deuxième plages sont disjointes au moins pour des tensions comprises dans ledit intervalle de lecture et dans lequel les première et deuxième plages présentent un écart d'au moins un facteur 100, au moins pour des tensions comprises dans ledit intervalle de lecture.

11. Procédé selon l'une quelconque des revendications précédentes, dans lequel les résistances des cellules mémoire dans le troisième état résistif (HRS programmé) sont comprises dans une troisième plage de valeurs, les première et troisième plages étant disjointes au moins pour des tensions comprises dans ledit intervalle de lecture et dans lequel les première et troisième plages présentent un écart d'au moins un facteur 100, au moins pour des tensions comprises dans ledit intervalle de lecture.

12. Procédé selon la revendication 1, dans lequel, au terme d'au moins un cycle d'étapes, on identifie, parmi les cellules de ladite pluralité de cellules, les cellules qui ne sont pas dans le deuxième état résistif (LRS) et on transfert le contenu des cellules identifiées à d'autres cellules mémoire.

13. Procédé selon l'une quelconque des revendications précédentes, dans lequel tout le courant passant entre les deux électrodes conductrices (120, 130) traverse le matériau diélectrique (110).

14. Procédé selon l'une quelconque des revendications précédentes, dans lequel l'étape d'assemblage comprend au moins l'une parmi les étapes suivantes : une étape de brasage, une étape de soudage, une étape d'assemblage par la technique dite de réalisation d'un boitier à la taille d'une puce au niveau du substrat (WLCSP).

## Patentansprüche

1. Verfahren zum Vorprogrammieren einer Matrix (300) aus nicht flüchtigen resistiven Speicherzellen, wobei die Speicherzellen (310, 320) ein dielektrisches Material (110) umfassen, das zwischen zwei leitenden Elektroden (120, 130) angeordnet ist, wobei das dielektrische Material (110) ein Oxid ist und mit jeder der zwei leitenden Elektroden (120, 130) in Kontakt steht, wobei sich die Speicherzellen (310, 320) anfänglich in einem ursprünglichen resistiven Zustand (ursprünglicher HRS) befinden und das dielektrische Material (110) in der Lage ist, elektrisch modifiziert zu werden, um die Speicherzelle aus dem ursprünglichen resistiven Zustand (ursprünglicher HRS) bis in mindestens einen anderen resistiven Zustand (LRS) zu bringen, in dem der Widerstand der Speicherzelle mindestens für ein Lesespannungsintervall mindestens zweimal, und vorzugsweise mindestens zehnmal kleiner ist als der Widerstand der Speicherzelle im ursprünglichen resistiven Zustand (ursprünglicher HRS), wobei das Verfahren die folgenden Schritte umfasst:
- vor dem Zusammenbauen eines die Matrix enthaltenden Bauteils auf einem Träger,
Programmieren der Matrix, indem eine Vielzahl von Zellen (320) elektrisch aus dem ursprünglichen resistiven Zustand (ursprünglicher HRS) bis in den anderen resistiven Zustand (LRS) gebracht werden, wobei der andere resistive Zustand ein zweiter resistiver Zustand ist,
Belassen der anderen Speicherzellen (310) in ihrem ursprünglichen resistiven Zustand (ursprünglicher HRS);
- Zusammenbauen der Matrix auf einem Träger,
**dadurch gekennzeichnet, dass** die Speicherzellen im Laufe des Schritts des Zusammenbauens einer Temperatur von mindestens 240 °C ausgesetzt werden, und
dadurch, dass das Verfahren nach dem Schritt des Programmierens und vor dem Zusammenbauen weiter mindestens einen Zyklus von Schritten umfasst, die an den Zellen der in den zweiten resistiven Zustand gebrachten Vielzahl von Zellen vorgenommen werden, wobei jeder Zyklus umfasst:
- ein elektrisches Modifizieren des dielektrischen Materials, um die Speicherzellen aus dem zweiten resistiven Zustand bis in einen dritten resistiven Zustand (programmierter HRS) zu bringen, in dem die Speicherzellen einen größeren Widerstand aufweisen als jenen der Speicherzellen im zweiten resistiven Zustand (LRS), und anschließend
- ein elektrisches Modifizieren des dielektrischen Materials, um die Zellen zurück in den zweiten resistiven Zustand zu bringen.

2. Verfahren nach dem vorstehenden Anspruch, wobei das Verfahren den folgenden Identifikationsschritt umfasst, der nach dem Zusammenbauen des die Matrix enthaltenden Bauteils auf dem Träger vorgenommen wird:
- bei mindestens einem Satz von Speicherzellen der Matrix, Anlegen einer Spannung, die dem Leseintervall entnommen ist;
- wenn die Zelle den Widerstand des ursprünglichen resistiven Zustands (ursprünglicher HRS) aufweist, Schlussfolgern, dass sich die Zelle nach dem Programmieren und vor dem Zusammenbauen im ursprünglichen resistiven Zustand (ursprünglicher HRS) befand; andernfalls Schlussfolgern, dass sich die Zelle nach dem Programmieren und vor dem Zusammenbauen nicht im ursprünglichen resistiven Zustand (ursprünglicher HRS) befand.

3. Verfahren nach einem der vorstehenden Ansprüche, wobei der andere resistive Zustand durch Anlegen einer Spannung direkt aus dem ursprünglichen resistiven Zustand (ursprünglicher HRS) erhalten wird.

4. Verfahren nach Anspruch 2 und Anspruch 3, wobei das Verfahren die folgenden Schritte umfasst, die nach dem Zusammenbauen des die Matrix enthaltenden Bauteils auf dem Träger vorgenommen werden:
- Identifizieren, ob sich die Speicherzelle im ursprünglichen resistiven Zustand (ursprünglicher HRS) befindet (412);
- wenn sich die Speicherzelle nicht im ursprünglichen resistiven Zustand (ursprünglicher HRS) befindet (412), Anlegen einer Spannung an die Speicherzelle, die größer ist als das Leseintervall, um die Speicherzelle in den zweiten resistiven Zustand (LRS) zurückzubringen oder in demselben zu halten.

5. Verfahren nach Anspruch 2, das weiter die folgenden Schritte umfasst, die nach dem Zusammenbauen des die Matrix enthaltenden Bauteils auf dem Träger vorgenommen werden:
- Identifizieren, ob sich die Speicherzelle im ursprünglichen resistiven Zustand (ursprünglicher HRS) befindet (412);
- wenn sich die Speicherzelle nicht im ursprünglichen resistiven Zustand (ursprünglicher HRS) befindet (412), Anlegen einer Spannung an die Speicherzelle, deren Amplitude größer ist als das Leseintervall, um die Speicherzelle in den dritten resistiven Zustand (programmierter HRS) zu bringen, in dem die Speicherzelle einen Widerstand aufweist, der durch Anlegen einer dem Leseintervall entnommenen Spannung vom Widerstand der Speicherzelle im ursprünglichen resistiven Zustand (ursprünglicher HRS) unterschieden werden kann.

6. Verfahren nach einem der vorstehenden Ansprüche 2 bis 5, wobei, wenn schlussgefolgert wird, dass sich die Speicherzelle im ursprünglichen resistiven Zustand (ursprünglicher HRS) befindet (412), die Speicherzelle im ursprünglichen resistiven Zustand (ursprünglicher HRS) belassen wird.

7. Verfahren nach den Ansprüchen 2 und 3, wobei, wenn identifiziert wird, dass sich die Speicherzelle im ursprünglichen resistiven Zustand (ursprünglicher HRS) befindet (412), die folgenden Schritte vorgenommen werden:
- elektrisches Modifizieren des dielektrischen Materials, um die Speicherzelle aus dem ursprünglichen resistiven Zustand (ursprünglicher HRS) bis in den zweiten resistiven Zustand (LRS) zu bringen,
- elektrisches Modifizieren des dielektrischen Materials, um die Speicherzelle aus dem zweiten resistiven Zustand (LRS) bis in den dritten resistiven Zustand (programmierter HRS) zu bringen, in dem die Speicherzelle einen Widerstand aufweist, der sich von jenem der Speicherzelle im zweiten resistiven Zustand (LRS) unterscheidet,
und wobei der Schritt des elektrischen Modifizierens des dielektrischen Materials, bis die Speicherzelle in den dritten resistiven Zustand (programmierter HRS) gebracht wird, ein RESET-Vorgang ist.

8. Verfahren nach dem vorstehenden Anspruch, wobei die Speicherzelle im dritten resistiven Zustand (programmierter HRS) einen Widerstand aufweist, der größer ist als jener der Speicherzelle im zweiten resistiven Zustand (LRS), sodass eine Leseschaltung identifizieren kann, ob sich die Zelle im zweiten resistiven Zustand (LRS) oder im dritten resistiven Zustand (programmierter HRS) befindet, vorzugsweise die Speicherzelle im dritten resistiven Zustand (programmierter HRS) einen Widerstand aufweist, der um mindestens einen Faktor 2, und vorzugsweise um mindestens einen Faktor 10 größer ist als der Widerstand der Speicherzelle im zweiten resistiven Zustand (LRS).

9. Verfahren nach einem der Ansprüche 2 bis 8, wobei der Identifikationsschritt an allen den Speicherzellen der Matrix vorgenommen wird.

10. Verfahren nach einem der vorstehenden Ansprüche, wobei die Widerstände der Speicherzellen der Matrix im ursprünglichen resistiven Zustand (ursprünglicher HRS) in einem ersten Wertebereich umfasst sind, die Widerstände der Speicherzellen im zweiten resistiven Zustand (LRS) in einem zweiten Wertebereich umfasst sind, und wobei der erste und zweite Bereich mindestens bei Spannungen, die im Leseintervall umfasst sind, disjunkt sind, und wobei der erste und zweite Bereich mindestens bei Spannungen, die im Leseintervall umfasst sind, einen Abstand von mindestens einem Faktor 100 aufweisen.

11. Verfahren nach einem der vorstehenden Ansprüche, wobei die Widerstände der Speicherzellen im dritten resistiven Zustand (programmierter HRS) in einem dritten Wertebereich umfasst sind, wobei der erste und dritte Bereich mindestens bei Spannungen, die im Leseintervall umfasst sind, disjunkt sind, und wobei der erste und dritte Bereich mindestens bei Spannungen, die im Leseintervall umfasst sind, einen Abstand von mindestens einem Faktor 100 aufweisen.

12. Verfahren nach Anspruch 1, wobei am Ende mindestens eines Schrittezyklus aus den Zellen der Vielzahl von Zellen die Zellen identifiziert werden, die sich nicht im zweiten resistiven Zustand (LRS) befinden, und der Inhalt der identifizierten Zellen an andere Speicherzellen übertragen wird.

13. Verfahren nach einem der vorstehenden Ansprüche, wobei der gesamte Strom, der zwischen den zwei leitenden Elektroden (120, 130) fließt, das dielektrische Material (110) durchfließt.

14. Verfahren nach einem der vorstehenden Ansprüche, wobei der Schritt des Zusammenbauens mindestens einen aus den folgenden Schritten umfasst: einen Schritt des Lötens, einen Schritt des Schweißens, einen Schritt des Zusammenbauens mit der Technik, die als Herstellung eines Gehäuses in der Größe eines Chips auf dem Substrat (WLCSP) bezeichnet wird.

## Claims

1. Method for pre-programming a matrix (300) of non-volatile resistive memory cells, said memory cells (310, 320) comprising a dielectric material (110) arranged between two conductive electrodes (120, 130), the dielectric material (110) being an oxide and being in contact with each of the two conductive electrodes (120, 130), said memory cells (310, 320) being initially in an original resistive state (original HRS) and the dielectric material (110) being capable of being electrically modified so as to bring the memory cell from the original resistive state (original HRS) to at least one other resistive state (LRS), wherein the resistance of the memory cell is at least twice, preferably at least ten times less than the resistance of the memory cell in the original resistive state (original HRS), at least for an interval of reading voltages, the method comprising the following steps:
- before assembling a component containing said matrix on a support,
programming the matrix by electrically bringing a plurality of cells (320) from the original resistive state (original HRS) to said other resistive state (LRS), said other resistive state being a second resistive state,
leaving the other memory cells (310) in the original resistive state thereof (original HRS);
- assembling said matrix on a support,
**characterised in that** during the assembly step, the memory cells are subjected to a temperature of at least 240°C, and
**in that** the method further comprises, after the programming step and before the assembly, at least one cycle of steps carried out on the cells of said plurality of cells brought to said second resistive state, each cycle comprising:
- an electrical modification of the dielectric material to bring said memory cells from said second resistive state to a third resistive state (programmed HRS), wherein the memory cells have a resistance greater than that of the memory cells in said second resistive state (LRS),
then
- an electrical modification of the dielectric material to bring said cells to said second resistive state.

2. Method according to the preceding claim, wherein the method comprises the following identification step carried out after assembly of the component containing said matrix on the support:
- for at least one set of memory cells of the matrix, applying a voltage taken in the reading interval;
- if the cell has the resistance of the original resistive state (original HRS), by deducing that the cell was in the original resistive state (original HRS) after programming and before assembly; otherwise, by deducing that the cell was not in the original resistive state (original HRS) after programming and before assembly.

3. Method according to any one of the preceding claims, wherein said other resistive state is directly obtained by applying a voltage from the original resistive state (original HRS).

4. Method according to claim 2 and claim 3, wherein the method comprises the following steps, carried out after assembly of the component containing said matrix on the support:
- identifying if the memory cell is in the original resistive state (original HRS) (412);
- if the memory cell is not in the original resistive state (original HRS) (412), applying to the memory cell, a voltage greater than said reading interval so as to bring back or to maintain the memory cell in said second resistive state (LRS).

5. Method according to claim 2, further comprising the following steps, carried out after assembly of the component containing said matrix on the support:
- identifying if the memory cell is in the original resistive state (original HRS) (412);
- if the memory cell is not in the original resistive state (original HRS) (412), applying to the memory cell, a voltage of which the amplitude is greater than said reading interval so as to bring the memory cell into the third resistive state (programmed HRS), wherein the memory cell has a resistance that can be distinguished from the resistance of the memory cell in the original resistive state (original HRS) by applying a voltage taken in the reading interval.

6. Method according to any one of the preceding claims 2 to 5, wherein if it is deduced that the memory cell is in the original resistive state (original HRS) (412), then the memory cell is left in the original resistive state (original HRS).

7. Method according to claims 2 and 3, wherein, if it is identified that the memory cell is in the original resistive state (original HRS) (412), then the following steps are carried out:
- electrically modifying the dielectric material to bring the memory cell from the original resistive state (original HRS) to the second resistive state (LRS),
- electrically modifying the dielectric material to bring the memory cell from the second resistive state (LRS) to the third resistive state (programmed HRS), wherein the memory cell has a resistance different from that of the memory cell in the second resistive state (LRS),
and wherein the step of electrically modifying the dielectric material until bringing the memory cell into said third resistive state (programmed HRS) is a RESET operation.

8. Method according to the preceding claim, wherein, in the third resistive state (programmed HRS), the memory cell has a resistance greater than that of the memory cell in the second resistive state (LRS), such that a reading circuit can identify if the cell is in the second resistive state (LRS) or in the third resistive state (programmed HRS), preferably, in the third resistive state (programmed HRS), the memory cell has a resistance greater than at least a factor 2, and preferably than at least a factor 10, to the resistance of the memory cell in the second resistive state (LRS).

9. Method according to any one of claims 2 to 8, wherein the identification step is carried out on all the memory cells of the matrix.

10. Method according to any one of the preceding claims, wherein the resistances of the memory cells of the matrix in the original resistive state (original HRS) are comprised in a first range of values, the resistances of the memory cell sin the second resistive state (LRS) are comprised in a second range of values, and wherein the first and second ranges are separate at least for the voltages within said reading interval and wherein the first and second ranges have a difference of at least a factor 100, at least for voltages within said reading interval.

11. Method according to any one of the preceding claims, wherein the resistances of the memory cells in the third resistive state (programmed HRS) are comprised in a third range of values, the first and third ranges being separate at least for voltages within said reading interval and wherein the first and third ranges have a difference of at least a factor 100, at least for voltages within said reading interval.

12. Method according to claim 1, wherein, at the end of at least one cycle of steps, the cells which are not in the second resistive state (LRS) are identified, from among the cells of said plurality of cells, and the content of the identified cells is transferred to other memory cells.

13. Method according to any one of the preceding claims, wherein the whole current passing between the two conductive electrodes (120, 130) passes through the dielectric material (110).

14. Method according to any one of the preceding claims, wherein the assembly step comprises at least one from among the following steps: a soldering step, a welding step, a step of assembling by the technique called producing a casing at the size of a chip at the level of the substrate (WLCSP).
